# EUROPEAN PATENT APPLICATION

(11) **EP 2 830 405 A1**
(43) Date of publication of application: **28.01.2015**
(21) Application number: 13765103.0
(22) Date of filing: 08.02.2013
(51) Int. Cl.: H05K 9/00

(54) **ELECTRONIC CONTROL DEVICE**

(30) Priority: 19.03.2012 JP 2012061371
(71) Applicant: Hitachi Automotive Systems, Ltd., Hitachinaka-shi, Ibaraki 312-8503 (JP)
(72) Inventor: KADOYA Kiyoomi, Hitachinaka-shi Ibaraki 312-8503 (JP); ISHIDA Ryosuke, Isesaki-shi Gunma 372-0023 (JP); MAYUZUMI Takuya, Hitachinaka-shi Ibaraki 312-8503 (JP); HOSHINO Kenichi, Isesaki-shi Gunma 372-0023 (JP); OKADA Yasuhiko, Isesaki-shi Gunma 372-0023 (JP); SUGIYAMA Yasushi, Isesaki-shi Gunma 372-0023 (JP)
(74) Representative: MERH-IP Matias Erny Reichl Hoffmann
(86) International application number: PCT/JP2013/052975
(87) International publication number: WO 2013/140884

(57) **Abstract**

An object of the present invention is to obtain a highly reliable, low-cost C/U structure that provides increased noise immunity.

Proposed is a C/U that is designed to accomplish the above object. The CU includes a multilayer circuit substrate 8, a resin cover 1, and a metal base 2. Electronic parts are mounted on both surfaces of the multilayer circuit substrate 8 which is covered with the resin cover 1 and the metal base 2. The multilayer circuit substrate 8 includes a signal pattern 4, a GND pattern 5, an important signal pattern 6, and a multilayer circuit substrate insulating layer 7. The GND pattern 5 is electrically connected to the metal base 2 through a screw 3. The GND pattern is disposed on the side of the resin cover 1 in order to shield the important signal pattern 6 against electromagnetic waves penetrating the resin cover 1 to enter a housing and electromagnetic waves incident from the metal base 2 side. The important signal pattern 6 is disposed so that it is covered with the GND pattern 5 and the metal case 2.

## Description

### Technical Field

The present invention relates to a vehicle-mounted electronic control unit and to a control unit mounted on an automobile, a marine engine, an agricultural machine, or a power tool.

### Background Art

In recent years, there is an increasing worldwide low-cost competition in the market of an electronic control unit (hereinafter referred to as the C/U). Therefore, for structural members of the C/U, such as internal circuit elements, circuit substrates, connectors, and housings, an increasing number of designs are implemented by using low-cost, easily locally-procured materials. In the past, an aluminum die-cast housing was used for a conventional waterproof C/U. In recent years, however, the material for such a housing is being superseded by resin because the resin is highly moldable and easily procured worldwide.

Meanwhile, environments in which the C/U is placed are degraded. Particularly, requirements related to electrical characteristics, such as noise immunity and surge resistance, are becoming increasingly stringent year after year. As regards noise immunity, the C/U needs to be designed so that it does not malfunction when it is irradiated with an external electromagnetic wave. In this document, the term "noise immunity" is used as an index indicating the degree of resistance against the external electromagnetic wave. It should be noted that increasing the noise immunity increases the reliability of the C/U.

When a housing made of resin is used for the C/U, there arises a problem in which an electromagnetic wave shielded conventionally by an aluminum die-cast housing may penetrate the C/U, thereby exposing substrate wiring patterns and electronic parts to the electromagnetic wave.

As such being the case, the noise immunity needs to be increased in order to increase the reliability of the C/U that uses a resin housing.

As means for solving the above problem, a circuit substrate 10 having a shielding layer 5 is disclosed in Patent Document 1. The shielding layer 5 is provided for a signal wiring 2 that is patterned on the circuit substrate 10. Therefore, when the circuit substrate 10 is exposed to an external electromagnetic wave, the shielding layer 10 blocks the electromagnetic wave. This results in an increase in the noise immunity of the signal wiring 2.

However, a structure for providing the shielding layer for the circuit substrate, which is described under "Background Art", is peculiar as compared to the structure of an ordinary glass-epoxy substrate and costly in terms of manufacture. Therefore, there arises a problem in which the price of the substrate having the shielding layer is higher than the price of the ordinary glass-epoxy substrate.

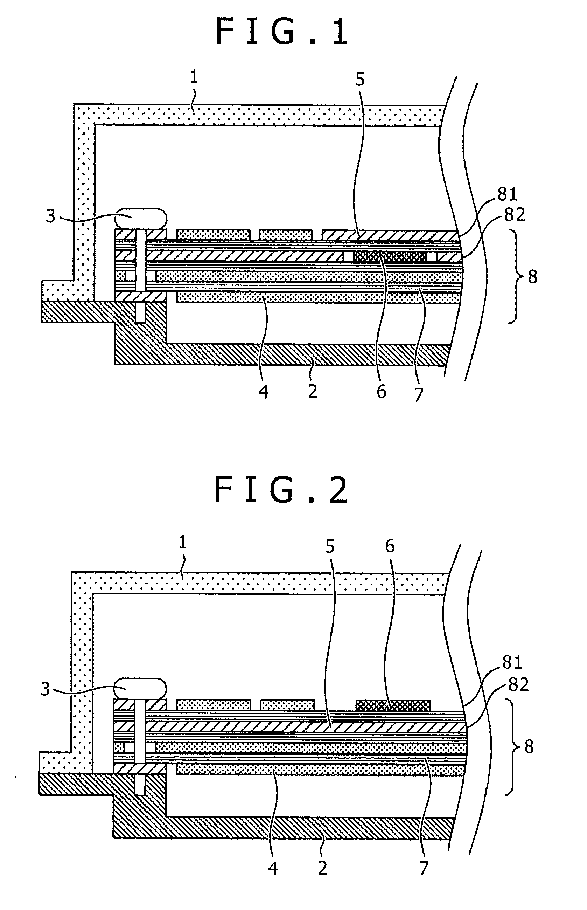

FIG. 2 is a cross-sectional view illustrating a typical conventional C/U.

A multilayer circuit substrate 8 on which electronic parts (not shown) are mounted is disposed in a space covered with a metal base 2. Therefore, external noise and electromagnetic waves are shielded by the metal base 2. This ensures that the multilayer circuit substrate and electronic parts remain unaffected. Hence, an important signal pattern 6, which includes a reset signal pattern, a power supply pattern, an oscillator circuit pattern, a watchdog circuit pattern, a fail-safe circuit pattern, and a communication circuit pattern, is protected against external noise and electromagnetic waves although it is disposed at any position on the multilayer circuit substrate 8.

However, when a conventional technology is adopted, the housing needs to use a metal that produces a shielding effect. Hence, there arises a problem in which resin and other low-cost materials cannot be used because electromagnetic waves penetrate them.

### Prior Art Literature

### Patent Document

Patent Document 1: JP-1994-112602-A

### Summary of the Invention

### Problems to be Solved by the Invention

An object of the present invention is to provide a highly reliable C/U structure by using an electromagnetic wave permeable housing to increase the noise immunity of a control unit.

### Means for Solving the Problems

To accomplish the above object, an electronic control unit according to the present invention includes a multilayer circuit substrate; a metal base for securing the multilayer circuit substrate; and a resin cover for covering the multilayer circuit substrate together with the metal base; wherein the multilayer circuit substrate includes a signal pattern, a GND pattern, an important signal pattern, and an insulating layer; and wherein the GND pattern is electrically connected to the metal base, and is disposed in a layer on the side of the resin cover rather than a layer in which the important signal pattern on the multilayer circuit substrate is disposed, thereby protecting the important signal pattern against electromagnetic waves.

### Effect of the Invention

The present invention makes it possible to obtain a highly reliable, low-cost C/U structure that provides increased noise immunity.

### Brief Description of the Drawings

FIG. 1 is a cross-sectional view of an electronic control unit according to a first embodiment of the present invention.
FIG. 2 is a cross-sectional view of an electronic control unit according to a conventional technology.
FIG. 3 is a cross-sectional view of an electronic control unit according to a second embodiment of the present invention.
FIG. 4 is a top view of a substrate of an electronic control unit according to a third embodiment of the present invention.
FIG. 5 is a cross-sectional view of an electronic control unit according to a fourth embodiment of the present invention.

### Mode for Carrying Out the Invention

FIG. 1 is a cross-sectional view of a C/U according to a first embodiment of the present invention. Reference numerals will now be described with reference to FIG. 1.

A multilayer circuit substrate 8, which is, for example, a glass epoxy substrate or a ceramic substrate, is disposed in a space covered with a resin cover 1 and a metal base 2. Electronic parts (not shown) are mounted on both surfaces of the multilayer circuit substrate 8. The electronic parts include an IC, a resistor, a capacitor, an inductor, and a mechanical relay.

The multilayer circuit substrate 8 has a signal pattern 4, a GND pattern 5, an important signal pattern 6, and a multilayer circuit substrate insulating layer 7. These elements are connected directly or indirectly to an external circuit for a power supply, a load, a sensor, a switch, or the like. The signal pattern 4 mainly includes a power supply pattern, a power supply solid layer, an input circuit pattern, an output circuit pattern, and a circuit pattern that interconnects the electronic parts. The GND pattern 5 includes a GND pattern, a GND solid layer, and a shielding GND pattern. The important signal pattern includes: a reset signal pattern that provides a signal affecting the control of the C/U and mainly supplies a reset signal for the electronic control unit; a power supply pattern; an oscillator circuit pattern for supplying a clock to the electronic parts; a watchdog circuit pattern for monitoring for abnormal electronic parts; a fail-safe circuit pattern for supplying a fail-safe signal when the electronic control unit becomes abnormal; and a communication circuit pattern for establishing communication between the electronic parts in the electronic control unit or communicating with the outside of the electronic control unit. The important signal pattern also includes a pattern that causes the C/U to stop running or go out of control when a malfunction due to external noise or electromagnetic waves occurs, a high-impedance signal pattern, and a digital signal pattern containing logical information "0" or "1". If, for instance, signal noise is generated by an electromagnetic wave in a situation where the reset signal for the C/U is represented by logical information "0" or "1", the C/U resets unexpectedly to create a safety hazard.

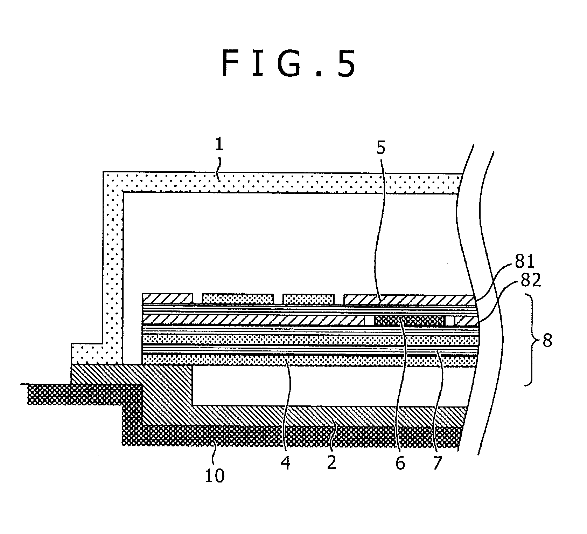

The GND pattern 5 in the multilayer circuit substrate 8 is electrically connected to the metal base 2 through an electrically conductive screw 3 so that the GND pattern 5 is on the same potential as the metal base 2. Thus, the space surrounded by the GND pattern 5 and the metal base 2 is electrically shielded and is a region protected against external noise and electromagnetic waves. The GND pattern 5 may be electrically connected to the metal base 2 by using electrically conductive resin instead of the electrically conductive screw 3. A waterproof sealing member may be used for a contact portion between the C/U's resin cover 1 and the metal base 2 in order to provide improved sealing performance. When a waterproof sealing member made of electrically conductive resin is used and brought into contact with the GND pattern 5, the electrically conductive resin electrically connects the metal base 2 to the GND pattern 5. If it is difficult to connect the metal base 2 to the GND pattern 5, it is preferred that the metal base be brought into contact with a vehicle body ground as shown in FIG. 5 so that the metal base is not in an electrical floating state.

A surface of the multilayer circuit substrate 8, which is positioned toward the resin cover 1 through which electromagnetic waves penetrate, is easily affected by external noise and electromagnetic waves. Hence, the important signal pattern 6 is not disposed on the surface of the multilayer circuit substrate 8, which is positioned toward the resin cover 1, but is disposed in a region covered with the GND pattern 5 and the metal base 2. In this instance, at least a portion of the important signal pattern 6 overlaps with the GND pattern 5 in a layer that is positioned toward the resin cover 1 of the multilayer circuit substrate 8. It is then expected that the same effect will be produced as in an electrically shielded region covered with the metal base 2 as shown in FIG. 2. This makes it possible to increase the noise immunity of the important signal pattern 6.

The electronic parts (not shown) mounted on a surface of the multilayer circuit substrate 8, which is positioned toward the metal base 2, are also protected against external noise and electromagnetic waves. Therefore, when electronic parts prone to malfunction are mounted on the surface of the multilayer circuit substrate 8, which is positioned toward the metal base 2, the noise immunity can be increased similarly.

When the important signal pattern 6 is disposed in a second layer 82 of the multilayer circuit substrate 8 as shown in FIG. 1, the noise immunity of the important signal pattern can be increased by disposing the GND pattern 5 in a first layer 81 of the multilayer circuit substrate, which is located above the second layer 82, and by connecting the GND pattern 5 in the second layer 82 of the multilayer circuit substrate to the GND pattern 5 in the first layer 81 of the multilayer circuit substrate through a via or the like.

The resin cover 1 is at a disadvantage in that it allows electromagnetic waves to penetrate unlike a metal cover 2. However, the resin cover 1 costs less than a metal cover 2 and is easily locally-procured worldwide.

As such being the case, the present invention adopts a two-piece housing structure having a cover and a base, and achieves cost reduction by using resin as the material for one of the two pieces. Further, the important signal pattern 6 and the GND pattern 5, which is disposed in a layer on the side of the resin cover 1 rather than a layer in which the important signal pattern 6 is disposed, are appropriately disposed to protect the important signal pattern 6 against electromagnetic waves, thereby obtaining a structure having increased noise immunity.

The present invention is also applicable to a control unit in which the multilayer circuit substrate 8 is hermetically sealed with a transfer-molded thermosetting resin instead of the resin cover 1. In this instance, the GND pattern 5 in a layer positioned toward the thermosetting resin of the multilayer circuit substrate 8 may be appropriately disposed to protect the important signal pattern 6 against electromagnetic waves penetrating the thermosetting resin, thereby obtaining a structure having increased noise immunity.

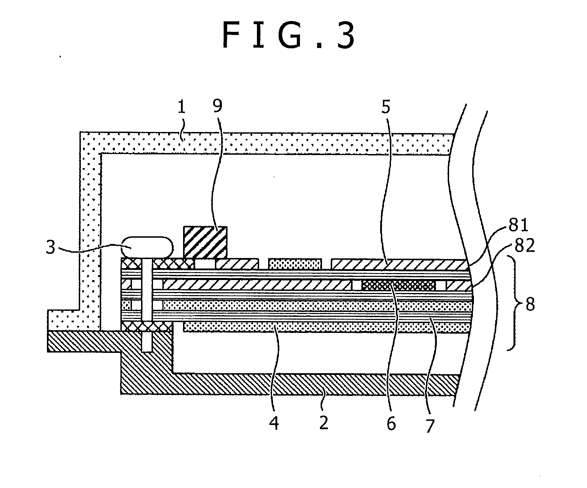

FIG. 3 is a cross-sectional view of the C/U according to a second embodiment of the present invention. Reference numerals will be described with reference to FIG. 3.

Reference numerals 1 to 8 are the same as those used in FIG. 1.

FIG. 3 differs from FIG. 1 in that the GND pattern 5 on the multilayer circuit substrate 8 is electrically connected to the metal base 2 through an electronic part 9.

A capacitor or a resistor is mainly used as the electronic part 9. The electronic part 9 is mounted to prevent the metal base 2 from being placed in an electrical floating state in a situation where it is necessary to prevent an electrical current from flowing from the GND pattern 5 to the vehicle body ground through the metal base 2 and the metal base 2 may not be connected to the vehicle body ground.

If a capacitor is used as the electronic part 9, the GND pattern 5 is insulated from the metal base 2 as regards a DC component, but the GND pattern 5 and the metal base 2 are in conduction as regards an AC component. As regards external noise and electromagnetic waves induced from an AC component, increased noise immunity can be obtained with respect to the space covered with the GND pattern 5 and the metal base 2 as described in conjunction with the first embodiment (FIG. 1).

If a resistor is used as the electronic part 9, the GND pattern 5 is connected to the metal base 2 as regards a DC component. However, the connection is usually established with a resistor of several hundred kilohms in order to ensure that an electrical current does not smoothly flow. As the resistor of several hundred kilohms provides a high-impedance state, the degree of noise immunity increase is smaller than that when a capacitor is used as the electronic part 9. However, it is possible to prevent the metal base 2 from being placed in an electrical floating state in a situation where the metal base 2 is not connected to the vehicle body ground. This makes it possible to prevent the metal base 2 from acting as an antenna to affect an internal circuit, thereby providing increased noise immunity.

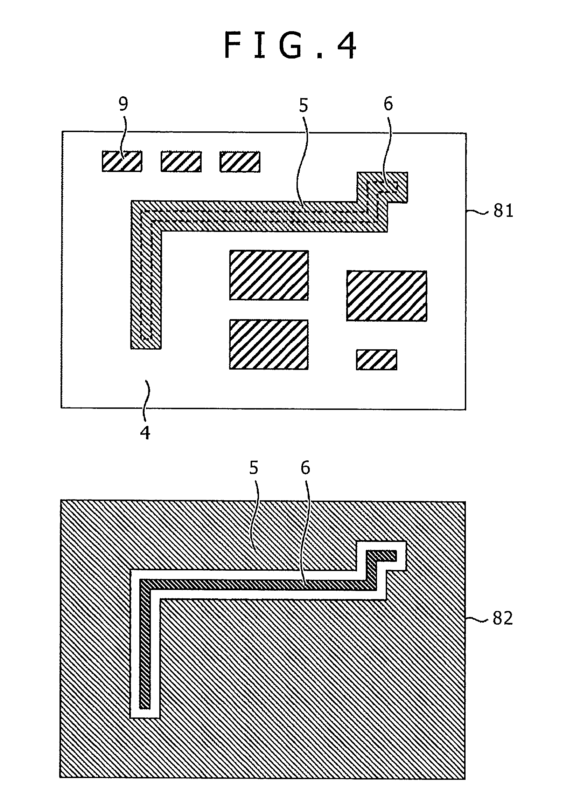

FIG. 4 is a top view of the substrate of the C/U according to a third embodiment of the present invention. Reference numerals will now be described with reference to FIG. 4.

Disposed in the second layer 82 of the multilayer circuit substrate is the important signal pattern 6, which includes the reset circuit pattern, the power supply pattern, the oscillator circuit pattern, a watchdog circuit pattern, the fail-safe circuit pattern, and the communication circuit pattern.

Meanwhile, in the first layer 81 of the multilayer circuit substrate, the GND pattern 5 covers the important signal pattern 6 in such a manner as to trace the important signal pattern 6 disposed in the second layer 82 of the multilayer circuit substrate 8. It is preferred that the GND pattern 5 be thicker than the important signal pattern 6. The reason is that electromagnetic waves penetrating from the side toward the resin cover 1 not only enter from a vertical top surface of the multilayer circuit substrate 8 but also enter in an oblique direction. When the above-described wiring is made; the GND pattern 5 shields the important signal pattern 6 against external noise and electromagnetic waves, thereby providing increased noise immunity.

Although FIG. 4 indicates that the important signal pattern 6 is disposed in the second layer, the important signal pattern 6 may alternatively be disposed in a third layer or in a fourth layer as far as it is shielded by the GND pattern 5. Similarly, the GND pattern 5 may be disposed in a layer other than the first layer as far as the GND pattern 5 is in a layer on the side of the resin cover 1 rather than a layer in which the important signal pattern 6 is disposed.

FIG. 5 is a cross-sectional view of the C/U according to a fourth embodiment of the present invention. Reference numerals will now be described with reference to FIG. 5.

Reference numerals 1 to 8 are the same as those used in FIG. 1.

FIG. 5 differs from FIG. 1 in that the GND pattern 5 on the multilayer circuit substrate 8 is not electrically connected to the metal base 2 through the screw 3, electrically conductive resin, or the like.

FIG. 5 is similar to FIG. 1 in that the important signal pattern 6 is covered with the GND pattern 5. In the present embodiment, the metal base 2 may be in an electrical floating state and act as an antenna due to external noise and electromagnetic waves, thereby affecting an internal circuit. To provide increased noise immunity, therefore, it is necessary to bring the metal base 2 into contact with the vehicle body ground 10.

The important signal pattern 6 is disposed in a space covered with the metal base 2 that is electrically connected to the GND pattern 5 and to the vehicle body ground 10. Therefore, a shielding effect is obtained to provide increased noise immunity.

The metal base 2 need not always be in planar contact with the vehicle body ground 10 as shown in FIG. 5. Alternatively, they may be in contact with each other at two or more fixed points.

Further, the GND pattern 5 may be formed in a layer positioned toward the metal base 2 in order to protect the important signal pattern 6 against electromagnetic waves generated from the side toward the metal base 2. An alternative in this instance is to replace the metal base 2 with a base made of resin or like material that transmits electromagnetic waves or secure the multilayer circuit substrate 8 with a transfer-molded thermosetting resin. The above alternative makes it possible to protect the important signal pattern 6 against electromagnetic waves even when the metal base 2 is in an electrical floating state or electromagnetic waves are transmitted through the base or thermosetting resin. This results in an increase in noise immunity.

Moreover, even when electromagnetic waves are transmitted through the base or thermosetting resin, a vehicle body mounting side need not always be provided with the GND pattern 5 for electromagnetic wave shielding.

The present invention, which has been described above, makes it possible to obtain a highly reliable, low-cost C/U structure that provides increased noise immunity.

### Description of Reference Numerals

- 1: Resin cover
- 2: Metal base
- 3: Screw
- 4: Signal pattern
- 5: GND pattern
- 6: Important signal pattern
- 7: Multilayer circuit substrate insulating layer
- 8: Multilayer circuit substrate
- 9: Electronic part
- 10: Vehicle body ground
- 81: First layer of multilayer circuit substrate
- 82: Second layer of multilayer circuit substrate

## Claims

1. An electronic control unit comprising:
a multilayer circuit substrate;
a metal base for securing the multilayer circuit substrate; and
a resin cover for covering the multilayer circuit substrate together with the metal base;
wherein the multilayer circuit substrate includes a signal pattern, a GND pattern, an important signal pattern, and an insulating layer; and
wherein the GND pattern is electrically connected to the metal base, and is disposed in a layer on the side of the resin cover rather than a layer in which the important signal pattern on the multilayer circuit substrate is disposed, thereby protecting the important signal pattern against electromagnetic waves.

2. The electronic control unit according to claim 1, wherein
the important signal pattern is any one of patterns including: a reset circuit pattern for supplying a reset signal for the electronic control unit; a power supply pattern; an oscillator circuit pattern for supplying a clock to electronic parts; a watchdog circuit pattern for monitoring for abnormal electronic parts; a fail-safe circuit pattern for supplying a fail-safe signal when the electronic control unit becomes abnormal; and a communication circuit pattern for establishing communication between the electronic parts in the electronic control unit or communicating with the outside of the electronic control unit.

3. The electronic control unit according to claim 2, wherein the GND pattern is disposed in a layer positioned toward the resin cover to cover the important signal pattern.

4. The electronic control unit according to claim 1, wherein the GND pattern is connected to the metal base through a capacitor.

5. The electronic control unit according to claim 1, wherein the GND pattern is connected to the metal base through a resistor.

6. An electronic control unit comprising:
a multilayer circuit substrate;
a metal base for securing the multilayer circuit substrate; and
a resin cover for covering the multilayer circuit substrate together with the metal base;
wherein the multilayer circuit substrate includes a signal pattern, a GND pattern, an important signal pattern, and an insulating layer;
wherein the metal base is electrically connected to a vehicle body ground, and the GND pattern is disposed in a layer on the side of the resin cover rather than a layer in which the important signal pattern on the multilayer circuit substrate is disposed, thereby protecting the important signal pattern against electromagnetic waves.

7. An electronic control unit comprising:
a multilayer circuit substrate; and
a thermosetting resin for hermetically sealing the multilayer circuit substrate;
wherein the multilayer circuit substrate includes a signal pattern, a GND pattern, an important signal pattern, and an insulating layer; and
wherein the GND pattern is disposed in a layer on the side of the thermosetting resin rather than a layer in which the important signal pattern on the multilayer circuit substrate is disposed, thereby protecting the important signal pattern against electromagnetic waves.

## Amended claims

### Amended claims under Art. 19.1 PCT

1. (Amended) An electronic control unit comprising:
a multilayer circuit substrate;
a metal base for securing the multilayer circuit substrate; and
a resin cover for covering the multilayer circuit substrate together with the metal base;
wherein the multilayer circuit substrate includes a signal pattern, a GND pattern, an important signal pattern, and an insulating layer; and
wherein the GND pattern is electrically connected to the metal base, and is disposed in a layer on the side of the resin cover rather than a layer in which the important signal pattern on the multilayer circuit substrate is disposed, in such a manner as to trace the important signal pattern, with the GND pattern formed having a width larger than that of the important signal pattern, thereby protecting the important signal pattern against electromagnetic waves.

2. The electronic control unit according to claim 1, wherein
the important signal pattern is any one of patterns including: a reset circuit pattern for supplying a reset signal for the electronic control unit; a power supply pattern; an oscillator circuit pattern for supplying a clock to electronic parts; a watchdog circuit pattern for monitoring for abnormal electronic parts; a fail-safe circuit pattern for supplying a fail-safe signal when the electronic control unit becomes abnormal; and a communication circuit pattern for establishing communication between the electronic parts in the electronic control unit or communicating with the outside of the electronic control unit.

3. The electronic control unit according to claim 2, wherein the GND pattern is disposed in a layer positioned toward the resin cover to cover the important signal pattern.

4. The electronic control unit according to claim 1, wherein the GND pattern is connected to the metal base through a capacitor.

5. The electronic control unit according to claim 1, wherein the GND pattern is connected to the metal base through a resistor.

6. (Amended) An electronic control unit comprising:
a multilayer circuit substrate;
a metal base for securing the multilayer circuit substrate; and
a resin cover for covering the multilayer circuit substrate together with the metal base;
wherein the multilayer circuit substrate includes a signal pattern, a GND pattern, an important signal pattern, and an insulating layer;
wherein the metal base is electrically connected to a vehicle body ground, and the GND pattern is disposed in a layer on the side of the resin cover rather than a layer in which the important signal pattern on the multilayer circuit substrate is disposed, in such a manner as to trace the important signal pattern, with the GND pattern formed having a width larger than that of the important signal pattern, thereby protecting the important signal pattern against electromagnetic waves.

7. (Amended) An electronic control unit comprising:
a multilayer circuit substrate; and
a thermosetting resin for hermetically sealing the multilayer circuit substrate;
wherein the multilayer circuit substrate includes a signal pattern, a GND pattern, an important signal pattern, and an insulating layer; and
wherein the GND pattern is disposed in a layer on the side of the thermosetting resin rather than a layer in which the important signal pattern on the multilayer circuit substrate is disposed, in such a manner as to trace the important signal pattern, with the GND pattern formed having a width larger than that of the important signal pattern, thereby protecting the important signal pattern against electromagnetic waves.

Statement under Art. 19.1 PCT
1. Description of Amendment

Claims 1, 6, and 7 are amended in accordance with paragraphs [0015] to [0041].

2. Explanation

No literature contains descriptions that disclose, suggest, or motivate configurations newly added by the amendment.
